Europäisches Patentamt

European Patent Office

Office européen des brevets

(19)

(11) **EP 1 343 017 B1**

(12) **EUROPÄISCHE PATENTSCHRIFT**

(45) Veröffentlichungstag und Bekanntmachung des
Hinweises auf die Patenterteilung:
**24.05.2006 Patentblatt 2006/21**

(51) Int Cl.:
*G01R 31/02* *(2006.01)*     *G01R 31/36* *(2006.01)*

(21) Anmeldenummer: **03001403.9**

(22) Anmeldetag: **22.01.2003**

(54) **Verfahren und Einrichtung zum Ermitteln der Funktionsfähigkeit einer Speicherbatterie**

Method and apparatus for determining the operability of a storage battery

Méthode et dispositif pour déterminer l'aptitude à fonctionner d'une batterie d'accumulateurs

(84) Benannte Vertragsstaaten:
**DE ES FR GB IT**

(30) Priorität: **09.03.2002 DE 10210516**

(43) Veröffentlichungstag der Anmeldung:
**10.09.2003 Patentblatt 2003/37**

(73) Patentinhaber: **VB Autobatterie GmbH & Co.
KGaA.
30419 Hannover (DE)**

(72) Erfinder: **Richter, Gerolf, Dr.
31139 Hildesheim (DE)**

(74) Vertreter: **Rehmann, Thorsten et al
GRAMM, LINS & PARTNER GbR,
Theodor-Heuss-Strasse 1
38122 Braunschweig (DE)**

(56) Entgegenhaltungen:
**EP-A- 1 116 958      DE-A- 19 952 693
US-A1- 2001 033 169**

**Beschreibung**

Die Erfindung betrifft ein Verfahren zum Ermitteln der Funktionsfähigkeit einer Speicherbatterie, insbesondere einer Starterbatterie für ein Kraftfahrzeug als Fähigkeit mindestens einen Verbraucher mit einer Energiemenge versorgen zu können, durch Ermitteln eines Kennwertes für den Ladezustand der Speicherbatterie und eines Kennwertes für die Gebrauchstüchtigkeit bei elektrischer Belastung der Speicherbatterie, wobei die Gebrauchstüchtigkeit die Eignung der Speicherbatterie ist, unter Einhaltung einer Mindestspannung eine bestimmte Energiemenge an den mindestens einen Verbraucher abzugeben.

Die Erfindung betrifft ferner eine Einrichtung zum Ermitteln des Zustandes einer Speicherbatterie, insbesondere einer Starterbatterie für Kraftfahrzeuge, mit Messmitteln zum Erfassen der Batteriespannung, der Batterietemperatur, des Lade- und Entladestroms und/oder des Ruhestroms und mit prozessorgesteuerten Auswertemitteln.

Bei dem Einsatz aufladbarer elektrochemischer Speicherbatterien, beispielsweise als Starterbatterien für ein Kraftfahrzeug, ist es erwünscht und in sicherheitskritischen Einsatzgebieten erforderlich, den Zustand der Speicherbatterie erkennen zu können.

Ein Problem stellt hierbei jedoch die Komplexität der Vorgänge im Akkumulator dar, die mit naturwissenschaftlichen Methoden nur schwer beschreibbar sind.

Beispielsweise aus der DE 195 40 827 C2 ist ein empirisches Verfahren zur Bestimmung des Alterungszustandes einer Batterie bekannt, bei der ein batteriespezifisches Kennfeld der Batteriealterung vorgegeben wird. Durch Erfassen von Momentanwerten der Batteriealterungseinflussgrößen bei der überwachten Batterie wird mit Hilfe des Kennfeldes ein Batteriealterungswert ermittelt.

Weiterhin ist aus der DE 199 60 761 C1 ein Verfahren zur Überwachung der Restladung und der Leistungsfähigkeit einer Speicherbatterie bekannt, bei dem durch mehrere Strom- und Spannungsmessungen bei unterschiedlichen Belastungszuständen der Speicherbatterie Messpunkte ermittelt und mit Hilfe von Interpolationsgeraden Schnittpunkte mit einem Grenzspannungs- und Grenzstromniveau bestimmt werden.

Nachteilig müssen diese Verfahren durch Konstanten und Funktionen, die mit einer Vielzahl von Experimenten zu ermitteln sind, an die jeweilige Bauform der Speicherbatterie und die geforderte Funktion der Speicherbatterie angepasst werden. Dies gilt insbesondere für Batterien in Kraftfahrzeugen mit Verbrennungsmotor, bei denen die Speicherbatterie im elektrischen Bordnetz bezüglich der an sie gestellten Anforderungen und Betriebsbedingungen einer völligen Stochastik unterliegt. So sind die Wechsel der Lade- und Entladeperioden sowie deren Intensität in Kombination beispielsweise mit den jeweiligen Batterietemperaturen rein statistisch verteilt und bedingt durch die Zufälligkeit des Fahrzyklusses nicht vorhersehbar.

Ein weiteres Problem ist, dass Leistungsreserven der Speicherbatterie zur Versorgung von sicherheitsrelevanten Verbrauchern, wie z. B. eine elektrische Lenkung und/oder elektrische Bremse, sichergestellt werden muss.

In der EP 1 116 958 A2 ist ein Verfahren zur Messung der Gebrauchstüchtigkeit einer Speicherbatterie bei elektrischer Belastung offenbart. Hierbei wird die Speicherbatterie mit einem Belastungsprofil beaufschlagt, d. h. ein definierter Strom oder eine Leistung wird über eine festgelegte Zeit entnommen, und die Spannungsantwort der Speicherbatterie gemessen. Der niedrigste bzw. höchste Spannungswert während der Beaufschlagung der Speicherbatterie mit dem Belastungsprofil ist ein Maß für die Gebrauchstüchtigkeit SOH (State of Health). Alternativ zur Beaufschlagung der Speicherbatterie mit einem Belastungsprofil kann der Gebrauchstüchtigkeitswert SOH auch aus dem Ladezustand SOC, des dynamischen Innenwiderstandes $R_i$ und der Temperatur der betrachteten Speicherbatterie rechnerisch ermittelt werden. Der Kennwert für die Gebrauchstüchtigkeit SOH beschreibt jedoch lediglich ein Maß für die Fähigkeit der Speicherbatterie eine Energiemenge in der erforderlichen Spannungslage zu liefern.

In der DE 199 52 693 A1 ist zudem ein Verfahren zum Ermitteln, Anzeigen und/oder Auslesen des Zustandes einer Speicherbatterie offenbart, bei dem die Batteriespannung, Batterietemperatur, Ladestrom, Entladestrom und/oder der Ruhestrom erfasst und hieraus über die Kennwerte für den Ladezustand SOC (State of Charge) als Funktion einer Ruhespannung ohne Last und der Batterietemperatur und des Kennwerts für die Gebrauchstüchtigkeit SOH (State of Health) eine Regelgröße für den Generator zur Speisung der Speicherbatterie abgeleitet wird.

Der Kennwert für den Ladezustand SOC beschreibt hierbei den Ladezustand der Speicherbatterie unter Berücksichtigung der ein- oder ausgeladenen Ladungsmenge.

Aufgabe der Erfindung war es, ein Verfahren und eine Einrichtung zum Ermitteln eines Kennwertes für die Funktionsfähigkeit SOF (State of Function) einer Speicherbatterie zu schaffen, wobei der Kennwert für die Funktionsfähigkeit über den Ladezustand SOC und die Gebrauchstüchtigkeit SOH hinaus ein Maß für die Wahrscheinlichkeit ist, dass die Speicherbatterie zu einem Zeitpunkt t eine Mindestenergie bereitstellen kann.

Erfindungsgemäß wird der Kennwert für die Funktionsfähigkeit SOF durch Verknüpfen der Kennwerte für den Ladezustand SOC und für die Gebrauchstüchtigkeit SOH ermittelt.

Im Unterschied zu herkömmlichen Verfahren wird der Zustand der Speicherbatterie durch Verwendung wahrscheinlichkeitstheoretischer Methoden beschrieben, wobei erkannt wurde, dass die beiden Kennwerte für den Ladezustand und die Gebrauchstüchtigkeit ausreichend sind, um die Funktionsfähigkeit der Speicherbatterie vorherzusagen.

Allgemein sind die Kennwerte SOX als "State of Performance" der Eigenschaft X zum Zeitpunkt t als Verhältnis des zum Zeitpunkt t noch vorhandenen Nutzungsintervalls der Eigenschaft X zum größtmöglichen Nutzungsintervall der Eigenschaft X definiert:

$$SOX\ (t)\ =\ \frac{\text{zum Zeitpunkt t noch vorhandenes Nutzungsintervall der Eigenschaft X}}{\text{größtmögliches Nutzungsintervall der Eigenschaft X}}$$

Die Kennwerte können auch als die Wahrscheinlichkeit P (t) dt definiert werden, das zum Zeitpunkt t innerhalb der Zeit t bis t+dt noch ein Restnutzen $\Delta x$ der Eigenschaft X vorliegt.

Im Unterschied zu den herkömmlichen analytischen Methoden erfolgt nunmehr eine einfache Verknüpfung der die Ladezustands- und Gebrauchstüchtigkeitswahrscheinlichkeit kennzeichnenden Kennwerte SOC und SOH.

Der Kennwert für den Ladezustand SOC zu einem Zeitpunkt t kann hierbei beispielsweise aus dem Verhältnis der Differenz der aktuellen Ladung $Q(t)$ und einer vorgegebenen kritischen Ladung $Q_{krit}$ und der Differenz aus der maximalen Ladung $Q_{max}$ der Speicherbatterie zu der vorgegebenen kritischen Ladung $Q_{krit}$ ermittelt werden.

Der Kennwert für den Ladezustand SOC zu einem Zeitpunkt t kann aber auch näherungsweise aus dem nernstschen Ladezustand $SOC_N$ aus dem Verhältnis zwischen der aktuellen Ruhespannungsdifferenz der aktuellen Ruhespannung $U_0(t)$ und der kritischen Ruhespannung $U_{0,krit}$ zur maximalen Ruhespannungsdifferenz der maximalen Ruhespannung $U_{0,max}$ und der kritischen Ruhespannung $U_{0,krit}$ bestimmt werden.

Die kritische Ladung $Q_{krit}$ und die kritische Ruhespannung $U_{0,krit}$ sind Grenzwerte, die die Versorgung von Verbrauchern über einen definierten Restzeitraum dt sicherstellen sollen.

Der Ladezustand SOC wird in obiger nernstscher Näherung als $SOC_N$ jedoch nur für den Fall einer neuwertigen Speicherbatterie mit ausreichender Genauigkeit beschrieben. Im Laufe der Nutzung der Speicherbatterie macht sich ein Alterungseffekt bemerkbar, wobei die dem Lade-/Entladeprozess nach Faraday zur Verfügung stehende Menge an aktiver Masse und/oder Säurekonzentration kontinuierlich abnimmt und gegebenenfalls eine Sulfatation von aktiver Masse auftritt. Die entnehmbare bzw. speicherbare Maximalkapazität der Speicherbatterie ist bei gealterten Batterien reduziert. Diesem Einfluss wird vorzugsweise dadurch Rechnung getragen, dass der Kennwert für den Ladezustand SOC aus dem nernstschen Ladezustand $SOC_N$ vermindert um einen Kennwert für die Ladezustandsveränderung $SOC_{N\Delta}$ aufgrund einer alterungsbedingten Änderung aktiver Masse der Speicherbatterie berechnet wird. Der Kennwert für die Ladezustandsveränderung $SOC_{N\Delta}$ wird vorzugsweise aus der Ladezustandsänderung aufgrund einer Verringerung einer aktiven Masse $SOC_{N\Delta m}$ und/oder aus der Ladezustandsänderung aufgrund einer Sulfatation von aktiver Masse $SOC_{N\Delta\rho}$ bestimmt.

Der Kennwert für die Gebrauchstüchtigkeit SOH wird vorzugsweise aus lastabhängigen Einbrüchen der Batteriespannung in bekannter Weise ermittelt.

Hierbei kann der Kennwert für die Gebrauchstüchtigkeit SOH beispielsweise als Verhältnis der Differenz einer aktuellen Entladespannung $U_{min}$ und dem Produkt einer vorgegebenen kritischen Entladespannung $U_{krit}$ mit dem Verhältnis eines Kennwertes für einen kritischen Ladezustand $SOC_{krit}$ zu dem Kennwert für den aktuellen Ladezustand SOC (t) zur Differenz einer vorgegebenen Normalentladespannung $U_{max}$ einer entsprechenden Speicherbatterie im Neuzustand und dem Produkt der vorgegebenen kritischen Entladespannung $U_{Krit}$ mit dem Kennwert für den kritischen Ladezustand $SOC_{krit}$ definiert sein.

Aufgrund der Definition der Kennwerte als Wahrscheinlichkeitsfunktionen kann der Kennwert für die Funktionsfähigkeit SOF einfach als Produkt der Kennwerte für den Ladezustand SOC und der Gebrauchstüchtigkeit SOH berechnet werden. Gleichermaßen wird der Kennwert für den Ladezustand SOC vorzugsweise aus dem Produkt der Kennwerte für den nernstschen Ladezustand $SOC_N$ und den Ladezustandsänderungen aufgrund Verringerungen aktiver Masse $SOC_{N\Delta m}$ und/oder der Ladezustandsänderung aufgrund Sulfatation aktiver Masse $SOC_{N\Delta\rho}$ berechnet.

Als Randbedingungen wird hierbei vorzugsweise festgelegt, dass der Kennwert für die Funktionsfähigkeit SOF gleich Null ist, wenn der Kennwert für den Ladezustand SOC kleiner oder gleich Null ist. Weiterhin sollte der Kennwert für die Funktionsfähigkeit SOF gleich Null sein, wenn der Kennwert für die Gebrauchstüchtigkeit SOH kleiner oder gleich Null ist.

Der Kennwert für den Ladezustand SOC wird vorzugsweise aus der entnehmbaren Ladungsmenge unter Normalbedingungen bei einer Temperatur im Bereich von 20 bis 30 °C, vorzugsweise 25°C, durch Messung des Entladestroms bestimmt, der sich bei Entladung einer vollgeladenen Speicherbatterie im Neuzustand für eine Zeitdauer von 5 bis 25 Stunden, vorzugsweise 20 Stunden einstellt.

Der auf die aktive Masse der Speicherbatterie bezogene Kennwert für die Ladezustandsveränderung $SOC_{N\Delta}$ wird vorzugsweise mit Hilfe des Innenwiderstands $R_i$ der Speicherbatterie ermittelt.

Die Aufgabe wird ferner durch die Einrichtung zum Ermitteln des Zustands einer Speicherbatterie gelöst, wobei prozessorgesteuerte Auswertemittel zur Durchführung des o. g. Verfahrens zur Ermittlung des Kennwertes für die Gebrauchstüchtigkeit ausgebildet sind.

Die Erfindung wird nachfolgend anhand der beigefügten Zeichnungen näher erläutert. Es zeigen:

Fig. 1 - Diagramm zur Bestimmung des Kennwertes für den Ladezustand SOC mit Korrektur bei Wasserverlust;

Fig. 2 - Diagramm zur Ermittlung des Kennwertes für den Ladezustand SOC mit Korrektur bei Wasserzugabe;

Fig. 3 - Diagramm zur Bestimmung des Kennwertes für den Ladezustand SOC mit Korrektur bei Säureverlust;

Fig. 4 - Diagramm zur Bestimmung des Kennwertes für den Ladezustand SOC mit Korrektur bei Verlust an aktiver Masse;

Fig. 5 - Diagramm zur Bestimmung des Kennwertes für den Ladezustand SOC mit Korrektur bei Sulfatation von aktiver Masse.

Für die vorliegende Erfindung ist der Kennwert für die Funktionsfähigkeit SOF (State of Function) einer Speicherbatterie definiert als das Verhältnis des verfügbaren Energieinhalts bis zum Erreichen einer kritischen Mindestenergie $E_{krit}$ bezogen auf den größtmöglichen nutzbaren Energieinhalt $E_{max}$.

Mit dem Kennwert der Funktionsfähigkeit SOF soll somit bestimmt werden, mit welcher Wahrscheinlichkeit zu einem Zeitpunkt t die Speicherbatterie noch in der Lage ist, eine Energiemenge in einer Qualität zu liefern, dass eine erforderliche physikalische Arbeit $W_{krit}$ entsprechend einem Mindestleistungsprofil $P_{krit}$ noch verrichtet werden kann. Beispielsweise soll festgestellt werden können, ob eine elektrische Bremse beim aktuellen Zustand der Speicherbatterie noch sicher betrieben werden kann.

Als entscheidende Eigenschaft der Speicherbatterie wird daher der Energieinhalt zum Zeitpunkt t

$$E(t) = U(t) \times \Delta Q(t)$$

und die daraus herzuleitende Wahrscheinlichkeit, mit der eine Mindestenergie bzw. kritische Energie

$$E_{Krit} = U_{Krit} \Delta Q_{Krit}$$

noch geliefert werden kann, herangezogen. Der Kennwert für die Funktionsfähigkeit SOF bei einer Temperatur T zum Zeitpunkt t ist dann wie folgt definiert:

$$SOF_T(t) = \frac{E(t) - E_{Krit}}{E_{max} - E_{Krit}} = \frac{U(t) \times \Delta Q(t) - U_{Krit} \times \Delta Q_{Krit}}{U_{max} \times \Delta Q_{max} - U_{Krit} \times \Delta Q_{Krit}}.$$

Für den Ladezustand einer Speicherbatterie zum Zeitpunkt t wird allgemein der Kennwert SOC wie folgt bestimmt:

$$SOC(t) = \frac{Q(t) - Q_{min}}{Q_{max} - Q_{min}}$$

und

$$SOC\left(t\right)=\frac{\Delta Q_{20}\left(t\right)}{C_{20}},$$

wobei Q (t), die sich in der Speicherbatterie befindliche und entnehmbare elektrische Ladung ist. Wenn die Ladung Q (t) zum Beispiel auf den Wert $Q_{min}$ absinkt, so ist der Kennwert SOC (t) gleich O. Im vollgeladenen Zustand wird die entnehmbare elektrische Ladung Q (t) zu $Q_{max}$, so dass dann SOC (t) gleich 1 ist. Der Kennwert für den Ladezustand SOC ist damit ein Maß für die Wahrscheinlichkeit, dass sich die Batterie im Zeitintervall t bis t + dt in einem bestimmten Ladezustand befindet bzw. dass im Zeitintervall t, t + dt noch eine nach dem Gesetz von Faraday eine unter normierten Entladebedingungen entnehmbarer Ladungsmenge vorhanden ist. Beispielsweise ist die Ladungsmenge $\Delta Q_{20}$ als Normgröße festgelegt, die bei Entladung mit einem 20stündigen Strom bei Raumtemperatur bis zu einer Entladegrenzspannung von 10,5 V der Speicherbatterie noch zu entnehmen ist, und welche bei einer neuwertigen, vollgeladenen Speicherbatterie mit einer Nennspannung von 12 V die Nennkapazität $C_{20}$ darstellt.

Da nach dem Faradayschen Gesetz ein elektrochemischer Speicher für die Aufnahme bzw. für die Abgabe einer bestimmten Ladungsmenge auch eine dazu proportionale Menge an Masse chemisch umwandeln muss, repräsentiert der Kennwert für den Ladezustand SOC zu jedem Zeitpunkt auch die Menge der noch zur Umsetzung verfügbaren aktiven Masse bzw. im Falle des Blei-/Säure-Akkumulators auch die Konzentration des noch zur Reaktion zur Verfügung stehenden Elektrolyten.

Über das bekannte Gesetz von Nernst besteht ein unmittelbarer Zusammenhang zwischen der nach dem faradayschen Gesetz zu- oder abnehmenden Säuredichte (Ladung oder Entladung) und der sogenannten Ruhespannung, das heißt der Klemmenspannung, zum Beispiel des unbelasteten Blei-/Säure-Akkumulators. Dieser Kennwert für den nernstschen Ladezustand $SOC_N$ ist in weiten Teilen des relevanten Ladezustandsbereiches direkt proportional zu der aktuellen Batterieruhespannung $U_0$. Es gilt somit in guter Näherung die folgende Beziehung:

$$SOC_N\left(t\right)\approx\frac{U_0\left(t\right)-U_{0,min}}{U_{0,max}-U_{0,min}}$$

Nur im Falle einer neuwertigen noch nicht diversen Alterungsprozessen unterworfenen Speicherbatterien ist der Kennwert für den nernstschen Ladezustand $SOC_N(t)$ dem allgemeinen Kennwert für den Ladezustand SOC (t) gleichzusetzen.

Im Laufe der Nutzung macht sich bei jeder Speicherbatterie allerdings ein Alterungseffekt bemerkbar. Die Beschreibung der Alterung ist äußerst komplex und kann beispielsweise empirisch mit Hilfe der Einflußgrößen Temperaturverlauf, Energiedurchsatz, Entladetiefe während der Lebensdauer abgeschätzt werden.

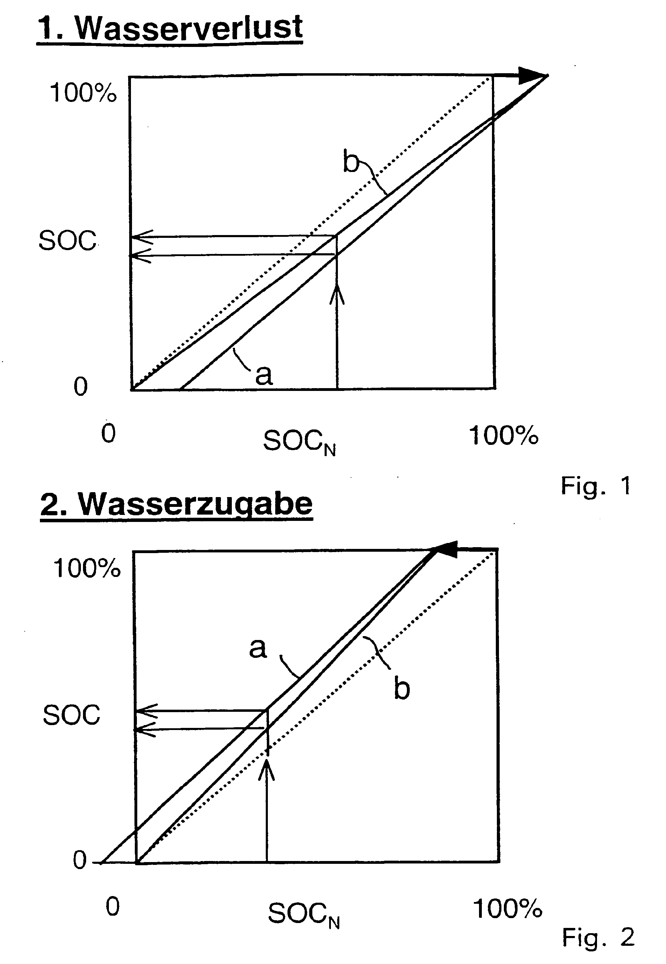

Die Alterungseinflüsse werden nachfolgend mit Hilfe der Figuren 1 bis 5 beispielhaft beschrieben.

Die Figur 1 lässt ein Diagramm zur Ermittlung des Kennwerts für den Ladezustand SOC bei einem Wasserverlust erkennen. Ein elektrolysebedingter Verlust an Wasser führt durch den "Eindickeffekt" der Batteriesäure zu einem Anstieg der Säurekonzentration. Bei säurereichen Speicherbatterie wirkt sich dieser Anstieg gleichmäßig über jeden Ladezustand aus, so dass das gestrichelt dargestellte Ausgangsverhältnis von tatsächlich entnehmbarer Ladungsmenge $SOC_F$ zum nernstschen Ladungszustand $SOC_N$ parallel nach unten verschiebt (Gerade a). Bei einer säurearmen Speicherbatterie kippt die dieses Verhältnis beschreibende Gerade lediglich nach unten (Gerade b).

Es ist erkennbar, dass bei gleichem nernstschen Ladezustand $SOC_N$ die tatsächlich entnehmbare Ladungsmenge der gealterten Batterie, d. h. der Kennwert für den Ladezustand SOC der gealterten Batterie, kleiner ist als der anfänglich durch die Zuordnung $SOC \approx SOC_N$ für die neue Batterie definerte Wert. Dieser besonders nach der Vollladung signifikante Effekt verstärkt sich auch in dem Bereich der Teilladung sowie nahe der völligen Entladung durch den Verlust bzw. das alterungsbedingte Abkoppeln von aktiver Masse. Dies gilt allerdings nur bei der Gruppe von masselimitierten Speicherbatterien.

Die Figur 2 lässt ein Diagramm zur Ermittlung des Kennwertes für den tatsächlichen Ladezustand SOC der gealterten Speicherbatterie bei einer Wasserzugabe erkennen. Durch die Zugabe von Wasser nimmt die Säurekonzentration ab und es wird ein zum Wasserverlust (vergl. Figur 1) entgegengesetzter Effekt erzielt.

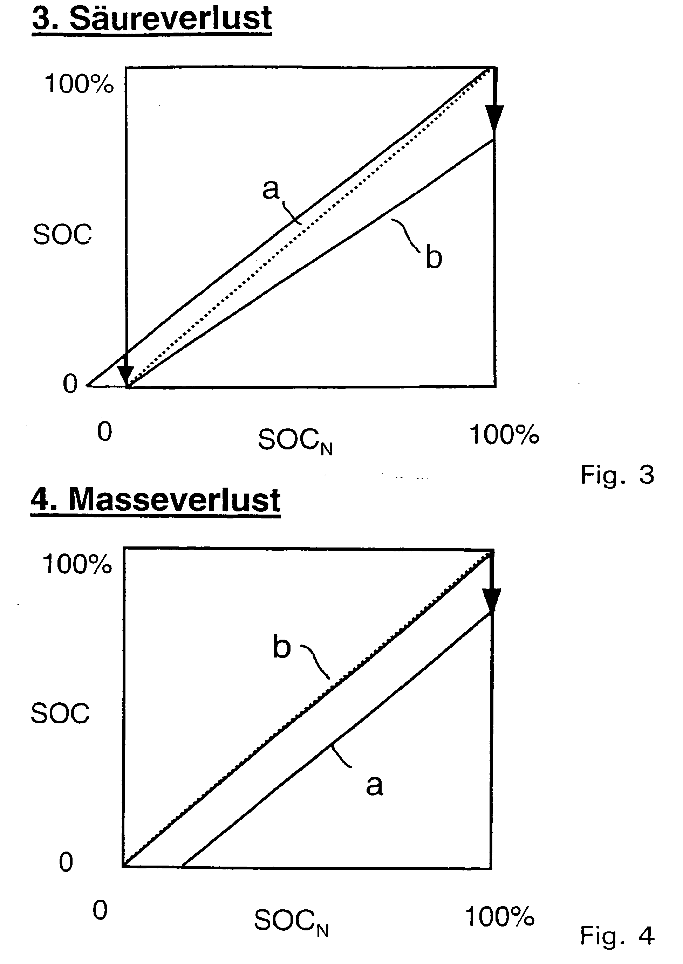

Die Figur 3 lässt ein Diagramm zur Ermittlung des Kennwerts für den tatsächlichen Ladezustand SOC einer gealterten Speicherbatterie bei Säureverlust erkennen. Bei einer säurereichen Speicherbatterie wirkt sich der Verlust an Säurekonzentration im vollgeladenen Zustand kaum aus. Im Bereich der starken Entladung führt es jedoch, ähnlich wie bei der zu der Figur 2 skizzierten Wasserzugabe zu einer Erhöhung des Kennwerts für den tatsächlichen Ladezustand SOC.

Bei einer säurearmen Speicherbatterie (Gerade b) führt ein Säureverlust hingegen zu einer Verringerung der tatsächlich entnehmbaren Ladungsmenge (Kennwert SOC).

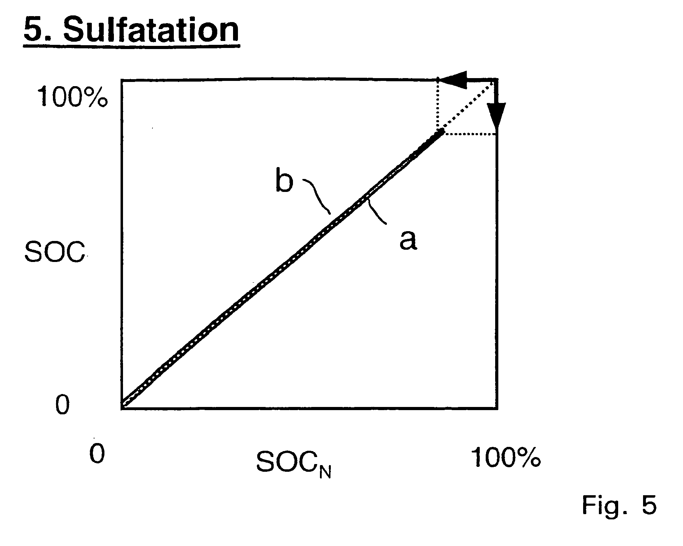

Die Figur 4 lässt ein Diagramm zur Ermittlung des Kennwerts für den tatsächlichen Ladezustand SOC bei einem Masseverlust erkennen. Bei einer säurearmen Speicherbatterie (Gerade b) hat ein Verlust an aktiver Masse kaum Auswirkungen auf die tatsächlich entnehmbare Ladungsmenge, da bei modernen Speicherbatterien die Säurekonzentration ein wesentlicher limitierender Faktor für die entnehmbare Ladungsmenge ist.

Bei einer säurereichen Speicherbatterie führt ein Masseverlust hingegen zu einem starken Absinken der entnehmbaren Ladungsmenge (vergl. Gerade a). Proportional über diesen gesamten Bereich des Kennwerts für den nernstschen Ladezustand $SOC_N$.

Die Figur 5 lässt das Diagramm zum Ermitteln eines Kennwerts für den tatsächlichen Ladezustand SOC bei Sulfatation erkennen. Bei modernen säurebegrenzten Speicherbatterien setzt parallel zum Wasserverlust der Effekt der Sulfatierung ein. Dies ist ein Vorgang, der der Eindickung des Elektrolyten entgegenwirkt, jedoch die maximal für die Speicherung von elektrischer Ladung zur Verfügung stehende Batteriekapazität fortlaufend einschränkt. Bei Sulfatation bleibt die Proportionalität zwischen der tatsächlichen entnehmbaren Ladungsmenge (Kennwert SOC) und der Ladungsmenge einer neuwertigen Batterie (gestrichelte Linie) erhalten. Lediglich die Maximalkapazität der Speicherbatterie sinkt mit fortschreitender Sulfatation/Alter.

Aufgrund dieser Zusammenhänge ist es zulässig, den Kennwert für den tatsächlichen Ladezustand SOC einer Speicherbatterie aus dem Produkt des über die ein- oder ausgeladene Ladungsmenge bestimmten nernstschen Ladezustand $SOC_N$ und der Ladezustandsverluste durch Veränderung kritischer Masse (Wasserverlust, Wasserzugabe, Säureverlust und Masseverlust) $SOC_{N\Delta m}$ und des Kennwertes für den Ladezustandsverlust aufgrund Sulfatation $SOC_{N\Delta\rho}$ zu berechnen. Für eine Überwachung einer Speicherbatterie wird kurzfristig über mathematische Modelle und/oder ein Verfahren zur Strombilanzierung der aktuelle nernstsche Ladezustand $SOC_N$ der Speicherbatterie in engen zeitlichen Perioden ermittelt. Weiterhin werden die Ladezustandsveränderungen durch Verlust aktiver Masse und Sulfatation $SOC_{N\Delta m}$ und $SOC_{N\Delta\rho}$ über die Korrelation des aktuellen Ladezustands mit dem Batteriegleichstrominnenwiderstand $R_i$ bei möglichst niedrigen Ladezuständen und niedrigen Temperaturen, z. B. mit Hilfe des Differentials $\dfrac{dU}{dI}$ berechnet.

Langfristig wird parallel zu der permanenten Überwachung der Differenz aus der ermittelten Ladungsmenge $SOC_N$ mit der in der Batterie tatsächlich vorhandenen Ladungsmenge (SOC) der Kennwert für die Ladezustandsveränderung $SOC_{N\Delta m}$ und $SOC_{N\Delta\rho}$ nachgeführt. In Perioden, in denen dieses nicht möglich oder eventuell unnötig ist (hohe Ladezustände, d. h. geringe Innenwiderstandsänderungen), muss durch mathematische Modelle auf Basis der kalendarischen Betriebszeit sowie dem bereits bis zu diesem Zeitpunkt erfolgten kumulatorischen Batterieladungsdurchsatzes bei den jeweiligen Elektrolyttemperaturen über sogenannte Alterungsfunktionen der Kennwert für die Ladezustandsänderung aufgrund aktiver Masse $SOC_{N\Delta M}$ und/oder aufgrund Sulfatation $SOC_{N\Delta\rho}$ ermittelt werden.

Ebenfalls wird langfristig aus der Differenz zwischen dem im Moment einer Belastung, z. B. beim Lenken oder Starten, beobachteten Spannungseinbruch und einem im Neuzustand gemessenen Spannungseinbruch bei gegebenen Ladezustand und Temperatur der Kennwert für die Gebrauchstüchtigkeit SOH ermittelt.

Aus dem Produkt der Kennwerte für den nernstschen Ladezustand $SOC_N$, der Ladezustandsveränderung aufgrund aktiver Masse $SOC_{N\Delta m}$, der Ladezustandsveränderung aufgrund Sulfatation $SOC_{N\Delta\rho}$ und dem Kennwert für die Gebrauchstüchtigkeit SOH kann dann die Wahrscheinlichkeit ermittelt werden, mit der bei gegebenen Bedingungen noch ein Verbraucher mit einem definierten Belastungsprofil versorgt werden kann. Als Bedingung kann z. B. sein, dass eine bestimmte Anzahl Lenkoperationen mit elektrischer Unterstützung aus der Starterbatterie eines Kraftfahrzeuges möglich sind.

Diese Wahrscheinlichkeit wird als Kennwert für die Funktionsfähigkeit SOF bezeichnet und entscheidet beispielsweise über die Einleitung weiterer Maßnahmen im Fahrzeug bishin zu einer Alarmierung des Fahrers.

Durch Ersetzen der kritischen Ladungsmenge $\Delta Q_{Krit}$, die für die sichere Funktion eines bestimmten elektrischen Aggregates, wie z. B. das n-malige Bremsen bei einer Spannungslage von mindestens $U_{Krit}$ erforderlich wäre durch den Ausdruck

$$\Delta Q_{Krit} = \Delta Q_{max} \; x \; SOC_{Krit}$$

bzw.

$$\Delta Q = \Delta Q_{max} \times SOC\,(t),$$

so berechet sich der Kennwert für die Funktionsfähigkeit zu

$$SOF\,(t) = SOC\,(t) \times \frac{U\,(t) - U_{Krit} \times \dfrac{SOC_{Krit}}{SOC\,(t)}}{U_{max} - U_{Krit} \times SOC_{Krit}}.$$

Hieraus ergibt sich eine erfindungsgemäße Definition für den Kennwert für die Gebrauchstüchtigkeit SOH (State of Health) zu:

$$SOH\,(t) = \frac{U\,(t) - U_{Krit} \times \dfrac{SOC_{Krit}}{SOC\,(t)}}{U_{max} - U_{Krit} \times SOC_{Krit}}.$$

Bei der Ermittlung des Kennwerts für die Funktionsfähigkeit aus der Verknüpfung des Kennwerts für den Ladezustand SOC und des Kennwerts für die Gebrauchstüchtigkeit SOH ist zu beachten, dass SOC größer oder gleich $SOC_{Krit}$ sein muss.

In den Gleichungen bezeichnen $U_{max}$ die maximale, $U(t)$ die aktuelle und $U_{Krit}$ die kritische Systemspannung. Auf diese Weise kann eine Speicherbatterie in einfacher Weise überwacht werden.

**Patentansprüche**

1. Verfahren zum Ermitteln der Funktionsfähigkeit einer Speicherbatterie, insbesondere einer Starterbatterie für ein Kraftfahrzeug, als Fähigkeit mindestens einen Verbraucher mit einer bestimmten Wahrscheinlichkreit zu einem Zeitpunkt t mit einer Energiemenge versorgen zu können, durch Ermitteln eines Kennwertes für den Ladezustand (SOC) der Speicherbatterie und eines Kennwertes für die Gebrauchstüchtigkeit (SOH) bei elektrischer Belastung der Speicherbatterie, wobei die Gebrauchstüchtigkeit (SOH) die Eignung der Speicherbatterie ist, unter Einhaltung einer Mindestspannung eine bestimmte Energiemenge an den mindestens einen Verbraucher abzugeben, **dadurch gekennzeichnet, dass** ein Kennwert für die Funktionsfähigkeit (SOF) durch Verknüpfen der Kennwerte für den Ladezustand (SOC) und für die Gebrauchstüchtigkeit (SOH) ermittelt wird.

2. Verfahren nach Anspruch 1, **gekennzeichnet durch** Ermitteln des Kennwertes für den Ladezustand (SOC) zu einem Zeitpunkt (t) aus dem Verhältnis der Differenz der aktuellen Ladung (Q(t)) und einer vorgegebenen kritischen Ladung ($Q_{krit}$) und der Differenz aus der maximalen Ladung ($Q_{max}$) der Speicherbatterie zu der vorgegebenen kritischen Ladung ($Q_{krit}$) ergibt

$$\left( SOC\,(t) \approx \frac{Q\,(t) - Q_{krit}}{Q_{max} - Q_{krit}} \right).$$

3. Verfahren nach Anspruch 1 oder 2, **gekennzeichnet durch** Ermitteln des Kennwertes für den Ladezustand (SOC) zu einem Zeitpunkt (t) aus einem nernstschen Ladezustand ($SOC_N$) aus dem Verhältnis zwischen der aktuellen Ruhespannungsdifferenz der aktuellen Ruhespannung ($U_0(t)$) und der kritischen Ruhespannung ($U_{0,krit}$) zur maximalen Ruhespannungsdifferenz der maximalen Ruhespannung ($U_{0,max}$) und der kritischen Ruhespannung ($U_{0,krit}$).

4. Verfahren nach Anspruch 2 oder 3, **gekennzeichnet durch** Ermitteln des Kennwertes für den Ladezustand (SOC)

aus dem nernstschen Ladezustand ($SOC_N$) vermindert um einen Kennwert für die Ladezustandsveränderung ($SOC_{N\Delta}$) aufgrund einer alterungsbedingten Änderung aktiver Masse.

5.  Verfahren nach Anspruch 4, **dadurch gekennzeichnet, dass** der Kennwert für die Ladezustandsänderung ($SOC_{N\Delta}$) aus der Ladezustandsänderung aufgrund einer Verringerung an aktiver Masse ($SOC_{N\Delta m}$) und aus der Ladezustandsänderung aufgrund einer Sulfatation von aktiver Masse ($SOC_{N\Delta\rho}$) bestimmt wird.

6.  Verfahren nach einem der vorhergehenden Ansprüche, **gekennzeichnet durch** Ermitteln des Kennwertes für die Gebrauchstüchtigkeit (SOH) aus lastabhängigen Einbrüchen der Batteriespannung.

7.  Verfahren nach einem der vorhergehenden Ansprüche, **dadurch gekennzeichnet, dass** der Kennwert für die Gebrauchstüchtigkeit (SOH) als Verhältnis der Differenz einer aktuellen Entladespannung (U (t)) und dem Produkt einer kritischen Entladespannung ($U_{Krit}$) mit dem Verhältnis eines Kennwertes für den Ladezustand ($SOC_{Krit}$) zu dem Kennwert für den aktuellen Ladezustand (SOC (t)) zur Differenz einer vorgegebenen Normalentladespannung ($U_{max}$) einer entsprechenden Speicherbatterie im Neuzustand und dem Produkt der vorgegebenen kritischen Entladespannung ($U_{Krit}$) mit dem Kennwert für den kritischen Ladezustand ($U_{Krit}$) ist

$$\left( SOH\ (t) = \frac{U\ (t) - U_{Krit}\ x\ SOC_{Krit}\ /\ SOC\ (t)}{U_{max} - U_{Krit}\ x\ SOC_{Krit}} \right) .$$

8.  Verfahren nach einem der vorhergehenden Ansprüche, **dadurch gekennzeichnet, dass** der Kennwert für die Funktionsfähigkeit (SOF) das Produkt der Kennwerte für den Ladezustand (SOC) und für die Gebrauchstüchtigkeit (SOH) ist.

9.  Verfahren nach einem der vorhergehenden Ansprüche, **dadurch gekennzeichnet, dass** der Kennwert für die Funktionsfähigkeit (SOF) gleich Null ist, wenn der Kennwert für den Ladezustand (SOC) kleiner oder gleich Null ist.

10. Verfahren nach einem der vorhergehenden Ansprüche, **dadurch gekennzeichnet, dass** der Kennwert für die Funktionsfähigkeit (SOF) gleich Null ist, wenn der Kennwert für die Gebrauchstüchtigkeit (SOH) kleiner oder gleich Null ist.

11. Verfahren nach einem der vorhergehenden Ansprüche, **dadurch gekennzeichnet, dass** der Kennwert für den Ladezustand (SOC) aus der entnehmbaren Ladungsmenge unter Normalbedingungen bei einer Temperatur im Bereich von 20 °C bis 30 °C durch Messung des sich einstellenden Entladestroms bei Entladung einer vollgeladenen Speicherbatterie im Neuzustand für eine Zeitdauer von 5 bis 25 Stunden bestimmt wird.

12. Verfahren nach einem der vorhergehenden Ansprüche, **gekennzeichnet durch** Ermitteln des auf die aktive Masse der Speicherbatterie bezogenen Kennwertes für die Ladezustandsveränderung ($SOC_{N\Delta}$) **durch** Bestimmung des Innenwiderstandes ($R_i$) der Speicherbatterie.

13. Einrichtung zum Ermitteln des Zustandes einer Speicherbatterie, insbesondere einer Starterbatterie für Kraftfahrzeuge mit Messmitteln zum Erfassen der Batteriespannung (U), der Batterietemperatur (T), des Lade- und Entladestroms (I) und/oder des Ruhestroms ($I_R$) und mit prozessorgesteuerten Auswertemitteln, **dadurch gekennzeichnet, dass** die Auswertemittel zur Durchführung des Verfahrens zum Ermitteln des Kennwertes für die Gebrauchstüchtigkeit (SOH) nach einem der vorhergehenden Ansprüche ausgebildet sind.

## Claims

1.  A method for determining the state of function of an energy storage battery, in particular a starter battery for a motor vehicle, as the capability to supply at least one load with a determined probability at a time (t) with an amount of energy, by determining a characteristic value for the state of charge (SOC) of the energy storage battery and a characteristic value for the state of health (SOH) when an electrical load is placed on the energy storage battery, with the state of health (SOH) being the suitability of the energy storage battery to emit a specific amount of energy to the at least one load while maintaining a minimum voltage, **characterized in that** a characteristic value for the state of function (SOF) is determined by linking the characteristic values for the state of charge (SOC) and for the state of health (SOH).

2. The method as claimed in claim 1 **characterized by** the characteristic value for the state of charge (SOC) being determined at a time (t) from the ratio of the difference between the present charge (Q(t)) and a predetermined critical charge ($Q_{krit}$) and the difference between the maximum charge ($Q_{max}$) of the energy storage battery and the predetermined critical charge ($Q_{krit}$) being given by

$$\left(SOC(t) \approx \frac{Q(t) - Q_{krit}}{Q_{max} - Q_{krit}}\right).$$

3. The method as claimed in claim 1 or 2, **characterized by** the characteristic value for the state of charge (SOC) at a time (t) being determined from a Nernst state of charge ($SOC_N$) from the ratio between the present no-load voltage difference between the present no-load voltage ($U_0(t)$) and the critical no-load voltage ($U_{0,krit}$), and the maximum no-load voltage difference between the maximum no-load voltage ($U_{0,max}$) and the critical no-load voltage ($U_{0,krit}$).

4. The method as claimed in claim 2 or 3, **characterized by** the characteristic value for the state of charge (SOC) being determined from the Nernst state of charge ($SOC_N$) minus a characteristic value for the change in the state of charge ($SOC_{N\Delta}$) resulting from an age-dependent change to the active mass.

5. The method as claimed in claim 4, **characterized in that** the characteristic value for the change in the state of charge ($SOC_{N\Delta}$) is determined from the change in the state of charge resulting from any reduction in the active mass ($SOC_{N\Delta m}$) and from the change in the state of charge resulting from sulfation of the active mass ($SOC_{N\Delta p}$).

6. The method as claimed in one of the preceding claims, **characterized by** the characteristic value for the state of health (SOH) being determined from load-dependent drops in the battery voltage.

7. The method as claimed in one of the preceding claims, **characterized in that** the characteristic value for the state of health (SOH) as the ratio of the difference between a present discharge voltage (U(t)) and the product of a critical discharge voltage ($U_{krit}$) and the ratio of a characteristic value for the state of charge ($SOC_{krit}$) to the characteristic value for the present state of charge (SOC(t)) to the difference between a predetermined normal discharge voltage ($U_{max}$) of a corresponding energy storage battery in the new state and the product of the predetermined critical discharge voltage ($U_{krit}$) and the characteristic value of the critical state of charge ($U_{krit}$) is given by:

$$\left(SOH(t) = \frac{U(t) - U_{krit} \times SOC_{krit} / SOC(t)}{U_{max} - U_{krit} \times SOC_{krit}}\right).$$

8. The method as claimed in one of the preceding claims, **characterized in that** the characteristic value for the state of function (SOF) is the product of the characteristic values for the state of charge (SOC) and for the state of health (SOH).

9. The method as claimed in one of the preceding claims, **characterized in that** the characteristic value for the state of function (SOF) is equal to zero, when the characteristic value for the state of charge (SOC) is less than or equal to zero.

10. The method as claimed in one of the preceding claims, **characterized in that** the characteristic value for the state of function (SOF) is equal to zero when the characteristic value for the state of health (SOH) is less than or equal to zero.

11. The method as claimed in one of the preceding claims, **characterized in that** the characteristic value for the state of charge (SOC) is determined from the amount of charge which can be drawn in normal conditions at a temperature in the range from 20°C to 30°C by measurement of the discharge current which occurs when discharging a fully charged energy storage battery in the new state for a time period of 5 to 25 hours.

**12.** The method as claimed in one of the preceding claims, **characterized by** the characteristic value relating to the active mass of the energy storage battery for the change in the state of charge (SOC$_{N\Delta}$) being determined by determining the internal resistance (R$_i$) of the energy storage battery.

**13.** A device for determining the state of an energy storage battery, in particular a starter battery for motor vehicles, with measurement means for detecting the battery voltage (U), the battery temperature (T), the charging and discharge currents (I) and/or the no-load current (I$_R$) and with processor-controlled evaluation means **characterized in that** the evaluation means are designed for carrying out the method for determining the characteristic value for the state of health (SOH) as claimed in one of the preceding claims.

**Revendications**

**1.** Procédé pour déterminer l'aptitude à fonctionner d'une batterie d'accumulateurs, notamment d'une batterie de démarrage pour un véhicule automobile, comme capacité avec une certaine probabilité à alimenter au moins un consommateur à un instant (t) avec une quantité d'énergie, en déterminant une valeur caractéristique de l'état de la charge (SOC) de la batterie d'accumulateurs et une valeur caractéristique de la disponibilité (SOH) pour une sollicitation électrique de la batterie d'accumulateurs, la disponibilité (SOH) étant la propriété de la batterie d'accumulateurs, de fournir tout en conservant une tension minimum, une quantité déterminée d'énergie à au moins un consommateur,
**caractérisé en ce qu'**
on détermine une valeur caractéristique de l'aptitude au fonctionnement (SOF) en combinant les valeurs caractéristiques de l'état de charge (SOC) et de la disponibilité (SOH).

**2.** Procédé selon la revendication 1,
**caractérisé en ce qu'**
on détermine la valeur caractéristique de l'état de charge (SOC) à un instant (t) à partir du rapport de la différence de la charge actuelle (Q(t)) et une charge critique (Q$_{crit}$) et la différence de la charge maximale (Q$_{max}$) de la batterie d'accumulateurs et de la charge critique prédéfinie (Q$_{crit}$) :

$$\left( SOC(t) \approx \frac{Q(t) - Q_{crit}}{Q_{max} - Q_{crit}} \right).$$

**3.** Procédé selon les revendications 1 et 2,
**caractérisé en ce qu'**
on détermine la valeur caractéristique de l'état de charge (SOC) à un instant (t) à partir de l'état de charge selon Nernst (SOC$_N$), selon le rapport de la différence actuelle de la tension de repos entre la tension de repos actuelle (U$_o$(t)) et la tension de repos critique (U$_{o,crit}$), par rapport à la différence maximale de tension de repos entre la tension de repos maximale (U$_{o,max}$) et la tension de repos critique (U$_{o,crit}$).

**4.** Procédé selon la revendication 2 ou 3,
**caractérisé en ce qu'**
on détermine la valeur caractéristique de l'état de charge (SOC) à partir de l'état de charge selon Nernst (SOC$_N$) diminué d'une valeur caractéristique de la variation d'état de charge (SOC$_N\Delta$) liée à une variation par vieillissement de la masse active.

**5.** Procédé selon la revendication 4,
**caractérisé en ce que**
la valeur caractéristique de la variation de l'état de charge (SOC$_N\Delta$) se détermine à partir de la variation de l'état de charge du fait d'une réduction de la masse active (SOC$_N\Delta_m$) et de la variation d'état de charge liée à la sulfatation de la masse active (SOC$_N\Delta_p$).

**6.** Procédé selon l'une des revendications précédentes,
**caractérisé en ce qu'**
on détermine la valeur caractéristique de la disponibilité (SOH) à partir des effondrements de la tension de la batterie en fonction de la charge.

**7.** Procédé selon l'une des revendications précédentes,
**caractérisé en ce que**
la valeur caractéristique de la disponibilité (SOH) est le rapport de la différence entre la tension de décharge actuelle (U(t)) et le produit d'une tension de décharge critique ($U_{crit}$) avec le rapport d'une valeur caractéristique de l'état de charge ($SOC_{crit}$) à la valeur caractéristique de l'état de charge actuel (SOC(t)), par rapport à la différence d'une tension de décharge normale prédéfinie ($U_{max}$) d'une batterie d'accumulateur correspondante à l'état neuf et le produit de la tension de décharge critique prédéfinie ($U_{crit}$) avec la valeur caractéristique de l'état de charge critique ($U_{crit}$) :

$$\left( SOH(t) = \frac{U(t) - U_{crit} \, x \, SOC_{crit} \, / \, SOC(t)}{U_{max} - U_{crit} \, x \, SOC_{crit}} \right)$$

**8.** Procédé selon l'une des revendications précédentes,
**caractérisé en ce que**
la valeur caractéristique de l'aptitude au fonctionnement (SOF) est le produit de la valeur caractéristique de l'état de charge (SOC) et de la disponibilité (SOH).

**9.** Procédé selon l'une des revendications précédentes,
**caractérisé en ce que**
la valeur caractéristique de l'aptitude au fonctionnement (SOF) est égale à zéro si la valeur caractéristique de l'état de charge (SOC) est inférieure ou égale à zéro.

**10.** Procédé selon l'une quelconque des revendications précédentes,
**caractérisé en ce que**
la valeur caractéristique de l'aptitude au fonctionnement (SOF) est égale à zéro si la valeur caractéristique de la disponibilité (SOH) est inférieure ou égale à zéro.

**11.** Procédé selon l'une quelconque des revendications précédentes,
**caractérisé en ce que**
la valeur caractéristique de l'état de charge (SOC) se détermine à partir de la quantité de charge qui peut être prélevée dans des conditions normales à une température de l'ordre de 20°C à 30°C par la mesure du courant de décharge qui s'établit lors de la décharge d'une batterie d'accumulateurs complètement chargée, à l'état neuf, pour une durée de 5 à 25 heures.

**12.** Procédé selon l'une des revendications précédentes,
**caractérisé en ce qu'**
on détermine la valeur caractéristique de la variation d'état de charge ($SOC_N\Delta$) rapportée à la masse active de la batterie d'accumulateurs en déterminant la résistance interne ($R_i$) de la batterie d'accumulateurs.

**13.** Installation pour déterminer l'état d'une batterie d'accumulateur notamment d'une batterie de démarrage de véhicule automobile avec des moyens de mesure pour saisir la tension de batterie (U), la température de batterie (T), le courant de charge et de décharge (I) et/ou le courant de repos (IR) et des moyens d'exploitation commandés par processeur,
**caractérisée en ce que**
le moyen d'exploitation est réalisé pour exécuter le procédé de détermination de la valeur caractéristique de la disponibilité (SOH) selon l'une des revendications précédentes.

# 1. **Wasserverlust**

Fig. 1

# 2. **Wasserzugabe**

Fig. 2

## 3. Säureverlust

Fig. 3

## 4. Masseverlust

Fig. 4

## 5. Sulfatation

Fig. 5